**Europäisches Patentamt**

**European Patent Office**

**Office européen des brevets**

(11) Veröffentlichungsnummer: **0 021 024**
**A1**

# EUROPÄISCHE PATENTANMELDUNG

(21) Anmeldenummer: **80102765.7**

(51) Int. Cl.³: **H 01 L 39/22**

(22) Anmeldetag: **20.05.80**

(30) Priorität: **03.07.79 DE 2926755**

(43) Veröffentlichungstag der Anmeldung: **07.01.81**
**Patentblatt 81/1**

(84) Benannte Vertragsstaaten: **FR GB NL**

(71) Anmelder: **Licentia Patent-Verwaltungs-GmbH,
Theodor-Stern-Kai 1, D-6000 Frankfurt/Main 70 (DE)**

(72) Erfinder: **Dahlberg, Reinhard, Dr., Innere Bergstrasse 32,
D-7101 Flein (DE)**

(74) Vertreter: **Maute, Hans-Jürgen, Dipl.-Ing. et al, Licentia
Patentverwaltungs-GmbH Theodor-Stern-Kai 1,
D-6000 Frankfurt/Main 70 (DE)**

(54) **Josephson-Junction-Anordnung.**

(57) Es wird eine Josephson-Junction-Anordnung beschrieben, bei welcher eine Vielzahl von elektrisch parallel geschalteten Punktkontakten gleicher Größe in regelmäßiger Verteilung in einem mechanisch stabilen Aufbau vorhanden ist.

Licentia Patentverwaltungs-G.m.b.H.
Theodor-Stern-Kai 1, 6000 Frankfurt 70


Heilbronn, den 08.05.79
SE2-HN-Ma-fi - HN 79/19


## Josephson-Junction-Anordnung

Die Erfindung beschreibt eine Josephson-Junction-Anordnung, bei welcher eine Vielzahl von definierten "Punkt-Kontakten" elektrisch parallel und mechanisch stabil angeordnet sind.

Bekanntlich bieten Bauelemente mit Josephson-Junctions viele Vorteile für den Bau schneller logischer Schaltungen. Magnetisch gesteuerte Josephson-Junctions werden vermutlich besonders bei ultraschnellen logischen Schaltungen Verwendung finden. Allerdings zeigen relativ großflächige Josephson-Junctions, die mit einem 10 - 20 Angström dicken Oxydfilm aufgebaut sind, eine Reihe von Nachteilen: der dünne Oxydfilm degradiert während der Abkühlzyklen und die Streukapazität dieser Junctions ist relativ groß.

Als Bauelemente ohne diese Nachteile haben sich deshalb Josephson-Junctions des sogenannten "micro-bridge"-Typs eingeführt. Bei diesem Typ wird die Barriere für die Cooper-Paare durch eine starke Einengung des Leitungspfades erzeugt. Damit zeigen diese Junctions praktisch keine Degradation und auch nur eine kleine Streukapazität. Eine spezielle Ausführung dieses Typs ist aber der Punkt-Kontakt-Junction, bei der eine feine Spitze auf eine glatte Fläche aufgesetzt ist. Derartige Josephson-Dioden sind mit Erfolg als rauscharme Mischer bei über 100 GHz, als Ultra-Hochfrequenz-Gleichrichter und als magnetisch gesteuerte logische Bauelemente verwendet worden.

Ein Nachteil der Punkt-Kontakt-Junction ist ihre relativ geringe magnetische Empfindlichkeit. Aus diesem Grunde wurde auch schon vorgeschlagen, zwei parallele Punkt-Kontakte zu verwenden (1). Ein Problem bei mehreren Punkt-Kontakten besteht in der mechanischen Stabilität und Justierung.

Die vorliegende Erfindung löst dieses Problem bei einer Josephson-Junction-Anordnung dadurch, daß zwei Platten oder Scheiben aus supraleitendem Material vorgesehen sind, daß mindestens eine Platte oder Scheibe auf einer Seite ihrer Oberfläche eine Struktur mit mindestens drei Erhebungen hat, und daß die Platten oder Scheiben unter mechanischem Druck so zusammengesetzt sind, daß an den Erhebungen Punkt-Kontakte zwischen den Platten oder Scheiben vorhanden sind.

Durch entsprechende Ausbildung der Erhebungen läßt sich erreichen, daß die Durchmesser der Punkt-Kontakte gleich groß sind. Die Drei-Punkt-Auflage gewährleistet eine optimale mechanische Stabilität.

Eine oder beide Platten oder Scheiben können außerdem auch noch mit einer sehr dünnen Isolatorschicht überzogen sein.

Eine bevorzugte Ausführungsform der Erfindung besteht darin, daß die Struktur auf der Oberfläche der Platten oder Scheiben aus parallelen Wällen besteht, und daß die beiden Platten oder Scheiben mit ihren strukturierten Oberflächen - in der Plattenebene gegeneinander verdreht - zusammengesetzt sind. Die Wälle in der Oberflächenstruktur kreuzen und berühren sich dann und bilden an den Berührungsstellen eine Anzahl von $N^2$ elektrisch parallelen Punkt-Kontakten, wenn N die Anzahl der parallelen Wälle in jeder Oberflächenstruktur ist. Das Prinzip der gekreuzten Wälle ist bereits in der Offenlegungsschrift P 25 47 262 beschrieben worden. Es wird dort jedoch nicht erwähnt, wie Josephson-Bauelemente nach diesem Prinzip hergestellt werden können.

Die strukturierte Oberfläche der Platten oder Scheiben kann mit einer Schicht aus einem harten Supraleiter, wie z. B. NbN, Mo-Re oder $Nb_3Ge$, überzogen sein, wobei die Schichtdicke größer als $1 . 10^{-4}$ cm ist.

Auf die strukturierte Seite mindestens einer Platte oder Scheibe kann auch eine Schicht von $3 . 10^{-6}$ bis $7 . 10^{-6}$ cm Dicke aus einer $Ge_xSn_{1-x}$-Legierung (mit $0,5 \leq x \leq 1$) aufgebracht sein. Diese Schichtzusammensetzungen gestatten eine gezielte Einstellung der Strom-Spannungs-Charakteristik.

Die Platten oder Scheiben können erfindungsgemäß auch auf ihren beiden Seiten eine definierte Struktur von Erhebungen tragen und es kann eine Vielzahl derartiger Scheibenpaare gestapelt unter Druck zusammengesetzt werden. Durch Anlegen eines Magnetfeldes kann die Josephson-Junction-Anordnung gesteuert werden. Sie läßt sich als Oszillator, Verstärker und als logisches Bauelement in an sich bekannter Weise verwenden. Sie gestattet auch die Herstellung von Josephson-Leistungsbauelementen.
Die Erfindung soll im folgenden an einigen Beispielen etwas näher erläutert werden.

Ausführungsbeispiele

Ausführungsbeispiel 1 zeigt eine Josephson-Junction-Anordnung mit drei parallelen Punkt-Kontakten.

Ausführungsbeispiel 2 zeigt eine Josephson-Junction-Anordnung mit einer Vielzahl von elektrisch parallelen Punkt-Kontakten.

Ausführungsbeispiel 3 zeigt eine elektrische Serienschaltung von Josephson-Junction-Anordnungen mit einer Vielzahl von elektrisch parallelen Punkt-Kontakten.

Ausführungsbeispiel 1

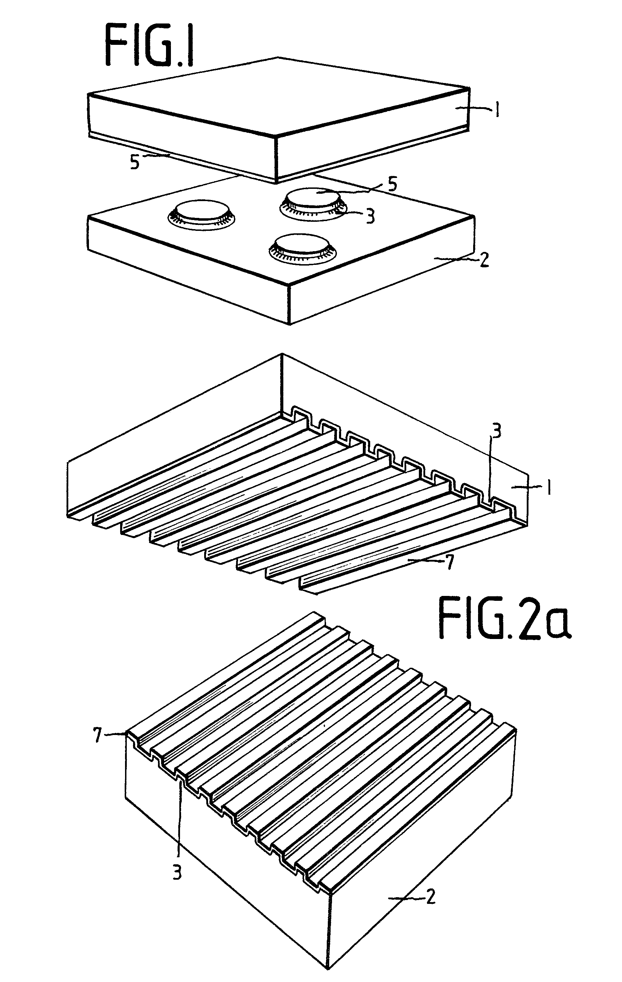

In Fig. 1 sind 1 und 2 quadratische Niob-Platten von beispielsweise 0,1 cm Kantenlänge und $1 \cdot 10^{-2}$ cm Dicke. Beide Platten 1 und 2 sind einseitig mit einer $6 \cdot 10^{-6}$ cm dicken Schicht 5 aus $Ge_{0,5}Sn_{0,5}$ überzogen. Die Niobplatte 2 hat auf einer Seite drei Kegelstümpfe 3 mit einer Höhe von $2 \cdot 10^{-2}$ cm und einem Durchmesser an der Spitze von $1 \cdot 10^{-3}$ cm. Nach dem Aufeinanderlegen und Fixieren der beiden Platten 1 und 2 entsteht eine Josephson-Junction-Anordnung mit drei elektrisch parallelen Junctions.

Ausführungsbeispiel 2

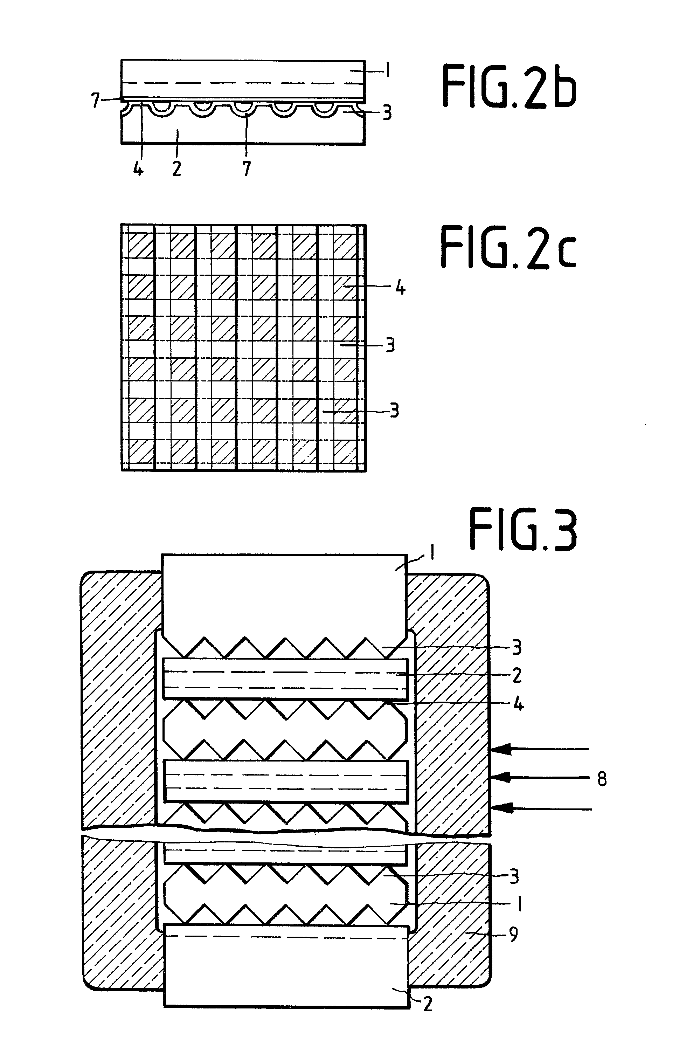

Fig. 2a zeigt schematisch zwei Platten 1, 2 aus Niob, die jeweils einseitig eine Struktur mit parallel aneinander verlaufenden Wällen 3 tragen, die jeweils durch Gräben voneinander getrennt sind. Die Strukturen auf beiden Platten 1, 2 sind mit einer $1 \cdot 10^{-4}$ cm dicken Schicht 7 aus NbN überzogen. Die Platte 1 ist in Fig. 2b um den Winkel $\alpha = 90°$ in der Plattenebene gegenüber der Platte 2 verdreht. Beide Platten werden mit den strukturierten Oberflächen unter Druck zusammengefügt. Die sich kreuzenden und berührenden Wälle 3 in den Strukturen der Platten 1, 2 bilden dadurch eine Vielzahl regelmäßig verteilter, gleichgroßer, elektrisch parallel geschalteter Punkt-Kontakte 4, wie in Fig. 2c ein Schnitt durch die Berührungsebene schematisch zeigt.

Ausführungsbeispiel 3

In Fig. 3 ist eine Vielzahl von Plattenpaaren 1 und 2 dargestellt, die beidseitig eine Struktur von parallelen Wällen 3 haben. Sie sind unter Druck so zusammengesetzt, daß sich alle parallelen Wälle 3 zweier Scheiben 1, 2 kreuzen und berühren. Dadurch entsteht eine Serienschaltung der elektrisch parallel geschalteten Punkt-Kontakte 4 zwischen je zwei Scheiben 1 und 2. 9 ist ein Gehäuse, beispielsweise aus Polycarbonat, und 8 ist ein Magnetfeld. Die Anordnung kann als quantenmechanisches Interferometer verwendet werden.

Auch als Mikrowellen-Generator mit größerer Leistung kann diese Anordnung ausgebildet werden.

Literatur

(1)   A.Th.A.M de Waele and R.de Bruyn Ouboter "Quantum Interference Phenomene in Point Contacts between two Superconductors"
Physica 41, 225-254 (1969)

- 6 -

0021024

## Bezugsziffern

1 Erste Platte oder Scheibe aus supraleitendem Material

2 Zweite Platte oder Scheibe aus supraleitendem Material

3 Erhöhung

4 elektrischer Kontakt

5 Schicht aus $Ge_x Sn_{1-x}$

6 dünne Isolatorschicht

7 Schicht aus z. B. $Nb_3 Ge$ oder NbN

8 Magnetfeld

9 Gehäuse aus Polycarbonat

0021024

Licentia Patent-Verwaltungs-G.m.b.H.
Theodor-Stern-Kai 1, 6000 Frankfurt 70


Heilbronn, den 08.05.79
SE2-HN-Ma-fi - HN 79/19


· Patentansprüche


1) Josephson-Junction-Anordnung, dadurch gekennzeichnet, daß zwei Platten oder Scheiben (1 und 2) aus supraleitendem Material vorgesehen sind, daß mindestens eine Platte oder Scheibe (1, 2) auf einer Seite ihrer Oberfläche eine Struktur mit mindestens drei Erhebungen (3) hat, und daß die Platten oder Scheiben (1 und 2) unter mechanischem Druck so zusammengesetzt sind, daß an den Erhebungen (3) Punkt-Kontakte (4) zwischen den Platten oder Scheiben (1, 2) vorhanden sind.


2) Josephson-Junction-Anordnung nach Anspruch 1, dadurch gekennzeichnet, daß der Durchmesser der Kontakte gleich groß ist.


3) Josephson-Junction-Anordnung nach einem der vorhergehenden Ansprüche, dadurch gekennzeichnet, daß eine dünne, bereits vor dem Zusammensetzen der beiden Platten oder Scheiben (1 und 2) aufgebrachte Isolatorschicht (6) auf der Struktur mindestens einer der beiden Platten oder Scheiben (1, 2) angeordnet ist.

4) Josephson-Junction-Anordnung nach einer der vorhergehenden Ansprüche, dadurch gekennzeichnet, daß die Struktur auf der Oberfläche der Platten oder Scheiben (1 und 2) aus parallelen Wällen (3) besteht, und daß die beiden Platten oder Scheiben (1 und 2) mit ihren strukturierten Oberflächen so in der Oberflächenebene gegeneinander verdreht zusammengesetzt sind, daß sich die jeweils parallel zueinander verlaufenden Wälle auf den Platten oder Scheiben kreuzen.

5) Josephson-Junction-Anordnung nach einem der vorhergehenden Ansprüche, dadurch gekennzeichnet, daß die strukturierte Oberfläche der Platten oder Scheiben (1 und 2) mit einer Schicht aus einem harten Supraleiter, wie z. B. NbN, Mo-Re oder $Nb_3Ge$ (7), mit einer Schichtdicke größer $1 \cdot 10^{-4}$ cm überzogen ist.

6) Josephson-Junction-Anordnung nach einem der vorhergehenden Ansprüche, dadurch gekennzeichnet, daß auf die strukturierte Seite mindestens einer Platte oder Scheibe (1 und 2) eine Schicht (5) von $3 \cdot 10^{-6}$ bis $7 \cdot 10^{-6}$ cm Dicke aus einer $Ge_xSn_{1-x}$-Legierung (mit $0,5 \leq x \leq 1$) zur Einstellung der Strom-Spannungs-Charakteristik aufgebracht ist.

7) Josephson-Junction-Anordnung nach einem der vorhergehenden Ansprüche, dadurch gekennzeichnet, daß die Platten oder Scheiben (1 und 2) auf beiden Seiten eine definierte Struktur von Erhöhungen (3) haben, und daß eine Vielzahl von Platten oder Scheiben (1 und 2) gestapelt unter Druck zusammengesetzt ist.

8) Josephson-Junction-Anordnung nach einem der vorhergehenden Ansprüche, gekennzeichnet durch ihre Verwendung für Oszillatoren, Verstärker und logische Bauelemente.

0021024

# FIG.1

# FIG.2a

FIG.2b

FIG.2c

FIG.3

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | GB - A - 1 222 624 (MULLARD LTD.)<br>* Seite 2, Zeilen 64-130; Seite 3, Zeilen 1-27; Figuren 1,2 * | 1-4,8 |
| | -- | |
| | FR - A - 2 099 025 (I.B.M.)<br>* Seite 6, Zeilen 25-33; Figuren 2A,B * | 1 |
| | ---- | |

**KLASSIFIKATION DER ANMELDUNG (Int.Cl. 3)**

H 01 L 39/22

**RECHERCHIERTE SACHGEBIETE (Int. Cl. 3)**

H 01 L 39/22

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 03-10-1980 | PELSERS |

EPA form 1503.1 06.78